(19) Europäisches Patentamt
European Patent Office
Office européen des brevets

(11) **EP 3 977 142 B1**

(12) **EUROPÄISCHE PATENTSCHRIFT**

(45) Veröffentlichungstag und Bekanntmachung des Hinweises auf die Patenterteilung:
**08.11.2023 Patentblatt 2023/45**

(21) Anmeldenummer: **19746047.0**

(22) Anmeldetag: **19.07.2019**

(51) Internationale Patentklassifikation (IPC):
***G01R 1/20*** *(2006.01)*

(52) Gemeinsame Patentklassifikation (CPC):
**G01R 1/203;** G01R 19/0092

(86) Internationale Anmeldenummer:
**PCT/EP2019/069515**

(87) Internationale Veröffentlichungsnummer:
**WO 2021/013318 (28.01.2021 Gazette 2021/04)**

(54) **ANORDNUNG ZUM ERMITTELN EINES DURCH EINE STROMSCHIENE FLIESSENDEN STROMS**

ARRANGEMENT FOR DETERMINING A CURRENT FLOWING THROUGH A BUSBAR

INSTALLATION DE DÉTERMINATION D'UN COURANT TRAVERSANT UNE BARRE OMNIBUS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**06.04.2022 Patentblatt 2022/14**

(73) Patentinhaber: **Siemens Energy Global GmbH & Co. KG**
**81739 München (DE)**

(72) Erfinder:
• **BECK, Michael**
**90610 Winkelhaid (DE)**
• **WENGLER, Alexander**
**96123 Melkendorf (DE)**

(56) Entgegenhaltungen:
WO-A1-2006/002446    US-A- 5 386 188
US-A1- 2015 301 148    US-A1- 2016 291 059

EP 3 977 142 B1

**Beschreibung**

Die Erfindung betrifft eine Anordnung zum Ermitteln der Größe eines durch eine Stromschiene fließenden elektrischen Stroms und ein derartiges Verfahren.

Die Patentanmeldung US 2016/291059 A1 offenbart eine Anordnung zum Ermitteln der Größe eines durch einen elektrischen Leiter fließenden Stroms. Diese Anordnung weist zwei Force-Anschlüsse zum Einspeisen eines Teststroms in den Leiter und zwei Sense-Anschlüsse zum Bereitstellen eines Eingangssignals, das sich auf einen Spannungsabfall über den Leiter bezieht, auf. Anhand des Eingangssignals und eines vordefinierten Referenzwiderstands, der mit dem Leiter verknüpft ist, wird der durch den Leiter fließende Strom bestimmt.

Aus der Patentanmeldung WO 2006/002446 A1 ist eine Einrichtung zur unterbrechungsfreien Strommessung an einer Stromschiene bekannt. Mittels einer Stromquelle wird dabei ein bekannter Referenzstrom erzeugt. Zur Ermöglichung einer genauen Strommessung an einer Stromschiene, bei der der Widerstand unbekannt und zeitlich veränderbar ist, wird der Referenzstrom (beispielsweise durch Frequenzmodulation) gekennzeichnet, um eine Unterscheidung vom zu messenden Strom durchzuführen.

Zum Ermitteln der Größe eines durch eine Stromschiene fließenden elektrischen Stroms war es bisher denkbar, einen herkömmlichen Stromwandler hoher Präzision, einen Strommess-Shunt aus einer speziellen Legierung oder eine sogenannte Zeroflux-Messstelle einzusetzen. Weiterhin könnte auch eine rein optische Methode zur Strommessung mittels eines speziellen Lichtwellenleiters eingesetzt werden. Diese Lösungen sind relativ aufwendig und teuer. Das gilt insbesondere dann, wenn die Messung in einem breiten Frequenzbereich des zu messenden Stroms durchgeführt werden soll und/oder wenn die Messung auf Hochspannungspotential durchgeführt werden soll.

Der Erfindung liegt die Aufgabe zugrunde, eine Anordnung und ein Verfahren anzugeben, mit denen die Größe eines durch eine Stromschiene fließenden Stroms mit geringem Aufwand ermittelt werden kann.

Diese Aufgabe wird erfindungsgemäß gelöst durch eine Anordnung und durch ein Verfahren nach den unabhängigen Patentansprüchen. Vorteilhafte Ausgestaltungen der Anordnung und des Verfahrens sind in den abhängigen Patentansprüchen angegeben.

Offenbart wird eine Anordnung zum Ermitteln der Größe eines durch eine Stromschiene fließenden Stroms, mit

- einem Messleiter, der an einem ersten Kontaktpunkt elektrisch mit der Stromschiene verbunden ist und der sich von dem ersten Kontaktpunkt zu einem zweiten Kontaktpunkt erstreckt,
- einem dritten Kontaktpunkt, der an der Stromschiene beabstandet von dem ersten Kontaktpunkt angeordnet ist,
- einer Spannungsmesseinrichtung, die zum Messen einer zwischen dem zweiten Kontaktpunkt und dem dritten Kontaktpunkt auftretenden Spannung eingerichtet ist, und
- einer geregelten Stromquelle, die zum Einleiten eines Messstroms in den Messleiter eingerichtet ist.

Bei dieser Anordnung ist besonders vorteilhaft, dass ein Teil der Stromschiene (nämlich der Teil der Stromschiene zwischen dem ersten Kontaktpunkt und dem dritten Kontaktpunkt) zum Ermitteln der Größe des Stroms mitverwendet wird. Der Teil der Stromschiene zwischen dem ersten Kontaktpunkt und dem dritten Kontaktpunkt bildet einen Strommess-Shunt (Strommess-Widerstand). Daher wird vorteilhafterweise als Strommess-Shunt kein zusätzliches Bauteil benötigt. Dadurch wird auch vorteilhafterweise das Entstehen von zusätzlicher Verlustleistung vermieden. Der Teil der Stromschiene zwischen dem ersten Kontaktpunkt und dem dritten Kontaktpunkt hat also eine Doppelfunktion: es dient als Stromleiter und er dient gleichzeitig als Strommess-Shunt. Zusätzlich zu der (sowieso vorhandenen) Stromschiene ist lediglich der Messleiter sowie einige elektronische Einrichtungen (Spannungsmesseinrichtung, geregelte Stromquelle) notwendig. Dadurch lässt sich der Strom mit geringem Aufwand und insbesondere auch bei hohen Frequenzen zuverlässig ermitteln.

Die Anordnung ist so ausgestaltet, dass die Größe des Messstroms so geregelt ist, dass die zwischen dem zweiten Kontaktpunkt und dem dritten Kontaktpunkt auftretende Spannung einen vorgewählten Wert, insbesondere den Wert Null, annimmt, und

- die Anordnung eine Auswerteeinrichtung aufweist, welche die Größe des durch die Stromschiene fließenden Stroms ermittelt aus der Größe des Messstroms, der für die Stromleitung wirksamen Querschnittsfläche des Messleiters und der für die Stromleitung wirksamen Querschnittsfläche der Stromschiene. Wenn die zwischen dem zweiten Kontaktpunkt und dem dritten Kontaktpunkt auftretende Spannung den vorgewählten Wert, insbesondere den Wert Null, annimmt, dann lässt sich die Größe des durch die Stromschiene fließenden Stroms besonders einfach ermitteln aus der Größe des Messstroms, aus der für die Stromleitung wirksamen Querschnittsfläche des Messleiters und aus der für die Stromleitung wirksamen Querschnittsfläche der Stromschiene. Die für die Stromleitung wirksame Querschnittsfläche des Messleiters und die für die Stromleitung wirksame Querschnittsfläche der Stromschiene sind bekannt und können insbesondere als konstant betrachtet werden.

Die Anordnung kann so ausgestaltet sein, dass die Auswerteeinrichtung die Größe des durch die Stromschiene fließenden Stroms ermittelt gemäß der Beziehung

$$I_S = k \; I_L \; A_S/A_L$$

wobei $I_S$ der durch die Stromschiene fließende Strom, keine Proportionalitätskonstante, $I_L$ der Messstrom, $A_S$ die für die Stromleitung wirksame Querschnittsfläche der Stromschiene und $A_L$ die für die Stromleitung wirksame Querschnittsfläche des Messleiters ist.

Die Ermittlung der Größe des Stroms in der Auswerteinrichtung ist vergleichsweise einfach, da neben dem (bekannten) durch den Messleiter fließenden Strom $I_L$ lediglich das Verhältnis der für die Stromleitung wirksamen Querschnittsfläche der Stromschiene $A_S$ und der für die Stromleitung wirksamen Querschnittsfläche des Messleiters $A_L$ benötigt wird. Mittels der Proportionalitätskonstante k können Eigenschaften des konstruktiven Aufbaus der Anordnung berücksichtigt werden, beispielsweise die Länge des Strompfades in der Stromschiene zwischen dem ersten Kontaktpunkt und dem dritten Kontaktpunkt, die Länge des Strompfades in dem Messleiter zwischen dem ersten Kontaktpunkt und dem zweiten Kontaktpunkt, das Material der Stromschiene und/oder das Material des Messleiters. Bei bestimmten Eigenschaften der Anordnung (beispielsweise wenn die Längen der Strompfade gleich groß sind und das Material der Stromschiene dem Material des Messleiters entspricht) kann die Proportionalitätskonstante k auch den Wert 1 annehmen.

Die Anordnung kann so ausgestaltet sein, dass der Messleiter und die Stromschiene aus demselben Material bestehen. Dabei ist vorteilhafterweise der spezifische Widerstand des Messleiters gleich dem spezifischen Widerstand der Stromschiene. Daher kann mittels der Auswerteinrichtung die Größe des durch die Stromschiene fließenden Stroms besonders einfach ermittelt werden.

Die Anordnung kann so ausgestaltet sein, dass der Messleiter an einer Oberfläche der Stromschiene angeordnet ist. Dabei ist vorteilhaft, dass der Messleiter im Wesentlichen dieselbe Temperatur annimmt wie die Stromschiene. Dadurch ist keine zusätzliche Temperaturmessung erforderlich und es kann auf eine vergleichsweise aufwändige Temperaturkompensation in der Auswerteinrichtung verzichtet werden.

Die Anordnung kann so ausgestaltet sein, dass der Messleiter im Wesentlichen in Flussrichtung des durch die Stromschiene fließenden Stroms an der Oberfläche der Stromschiene angeordnet ist. Dabei ist besonders vorteilhaft, dass der Messleiter die relevante Temperatur der Stromschiene annimmt (die insbesondere durch die stromflussbedingte Erwärmung der Stromschiene beeinflusst wird).

Die Anordnung kann so ausgestaltet sein, dass die Stromschiene eine rohrförmige Stromschiene ist. Derartige Stromschienen können insbesondere mit Vorteil im Hochspannungsbereich eingesetzt werden.

Die Anordnung kann auch so ausgestaltet sein, dass der Messleiter an der inneren Oberfläche der rohrförmigen Stromschiene angeordnet ist. Bei dieser Ausführungsform liegt der Messleiter geschützt an der inneren Oberfläche der rohrförmigen Stromschiene.

Die Anordnung kann auch so ausgestaltet sein, dass der Messleiter, die Spannungsmesseinrichtung, die geregelte Stromquelle und/oder die Auswerteinrichtung in einem Innenraum der rohrförmigen Stromschiene angeordnet sind. Dabei sind der Messleiter, die Spannungsmesseinrichtung, die geregelte Stromquelle und/oder die Auswerteinrichtung geschützt im Innenraum der rohrförmigen Stromschiene angeordnet. Sie sind damit insbesondere auch witterungsgeschützt angeordnet und nur einer sehr geringen elektromagnetischen Belastung ausgesetzt. Der Innenraum der rohrförmigen Stromschiene ist nämlich praktisch frei von elektromagnetischen Feldern (Feldfreiheit des Rohrinneren).

Die Anordnung kann auch so ausgestaltet sein, dass der Messleiter auf die Oberfläche der Stromschiene geklebt ist. Dadurch kann der Messleiter auf einfache Art und Weise isoliert auf die Oberfläche der Stromschiene aufgebracht werden. Durch die Verklebung kann darüber hinaus sichergestellt werden, dass der Messleiter schnell die Temperatur der Stromschiene annimmt.

Die Anordnung kann auch einen Energieübertragungskanal zur Energieversorgung der Spannungsmesseinrichtung, der geregelten Stromquelle und/oder der Auswerteinrichtung aufweisen.

Der Energieübertragungskanal kann beispielsweise als ein erster Lichtwellenleiter oder ein erster elektrischer Leiter ausgestaltet sein. Der Energieübertragungskanal verbindet also eine außerhalb der Stromschiene angeordnete Energieversorgungseinrichtung mit der Spannungsmesseinrichtung, der geregelten Stromquelle und/oder der Auswerteinrichtung. Über diesen Energieübertragungskanal kann insbesondere elektrische Energie in den Innenraum der rohrförmigen Stromschiene übertragen werden.

Die Anordnung kann auch einen Kommunikationskanal zur Übertragung der ermittelten Größe (d.h. des ermittelten Wertes) des durch die Stromschiene fließenden elektrischen Stroms aufweisen.

Der Kommunikationskanal kann beispielsweise als ein zweiter Lichtwellenleiter oder ein zweiter elektrischer Leiter ausgestaltet sein. Der Energieübertragungskanal und der Kommunikationskanal können auch als ein gemeinsamer Lichtwellenleiter oder ein gemeinsamer elektrischer Leiter ausgestaltet sein. Über den Kommunikationskanal können also Daten betreffend die ermittelte Größe des durch die Stromschiene fließenden elektrischen Stroms von der Stromschiene weg übertragen werden (Kommunikationskanal zur Datenübertragung). Der Kommunikationskanal ermöglicht insbesondere die Übertragung von Daten aus dem Innenraum der rohrförmigen Stromschiene hinaus zu einer (stromschienenexternen) datenverarbeitenden Einrichtung.

Die Anordnung kann auch so ausgestaltet sein, dass die Länge des Strompfads in der Stromschiene zwischen dem ersten Kontaktpunkt und dem dritten Kontaktpunkt im Wesentlichen der Länge des Strompfads in dem Messleiter zwischen dem ersten Kontaktpunkt und dem zweiten Kontaktpunkt entspricht. In diesem Fall lässt sich der durch die Stromschiene fließende Strom besonders einfach ermitteln, da beide Strompfade gleich lang sind.

Offenbart wird weiterhin ein Verfahren zum Ermitteln der Größe eines durch eine Stromschiene fließenden Stroms, mit

- einem Messleiter, der an einem ersten Kontaktpunkt elektrisch mit der Stromschiene verbunden ist und der sich von dem ersten Kontaktpunkt zu einem zweiten Kontaktpunkt erstreckt,
- einem dritten Kontaktpunkt, der an der Stromschiene beabstandet von dem ersten Kontaktpunkt angeordnet ist, wobei bei dem Verfahren
- die zwischen dem zweiten Kontaktpunkt und dem dritten Kontaktpunkt auftretende Spannung gemessen wird,
- in den Messleiter ein Messstrom eingeleitet wird,
- die Größe des Messstroms so geregelt wird, dass die zwischen dem zweiten Kontaktpunkt und dem dritten Kontaktpunkt auftretende Spannung einen vorgewählten Wert, insbesondere den Wert Null, annimmt, und
- die Größe des durch die Stromschiene fließenden Stroms ermittelt wird aus der Größe des Messstroms, der für die Stromleitung wirksamen Querschnittsfläche des Messleiters und der für die Stromleitung wirksamen Querschnittsfläche der Stromschiene.

Das Verfahren kann so ablaufen, dass die Größe des durch die Stromschiene fließenden Stroms ermittelt wird gemäß der Beziehung

$$I_S \;=\; k \;\; I_L \;\; A_S/A_L$$

wobei $I_S$ der durch die Stromschiene fließende Strom, keine Proportionalitätskonstante, $I_L$ der Messstrom, $A_S$ die für die Stromleitung wirksame Querschnittsfläche der Stromschiene und $A_L$ die für die Stromleitung wirksame Querschnittsfläche des Messleiters ist.

Das Verfahren kann so ablaufen, dass der Messleiter und die Stromschiene aus demselben Material bestehen.

Das Verfahren kann auch eines, mehrere oder alle der übrigen Merkmale aufweisen, die oben im Zusammenhang mit der Anordnung genannt sind. Das Verfahren und die Anordnung weisen gleichartige Vorteile auf, insbesondere die oben im Zusammenhang mit der Anordnung angegebenen Vorteile.

Im Folgenden wird die Erfindung anhand eines Ausführungsbeispiels näher erläutert. Dazu ist in der

Figur ein Ausführungsbeispiel einer Anordnung zum Ermitteln der Größe eines durch eine rohrförmige Stromschiene fließenden Stroms sowie das dabei ablaufende Verfahren

dargestellt.

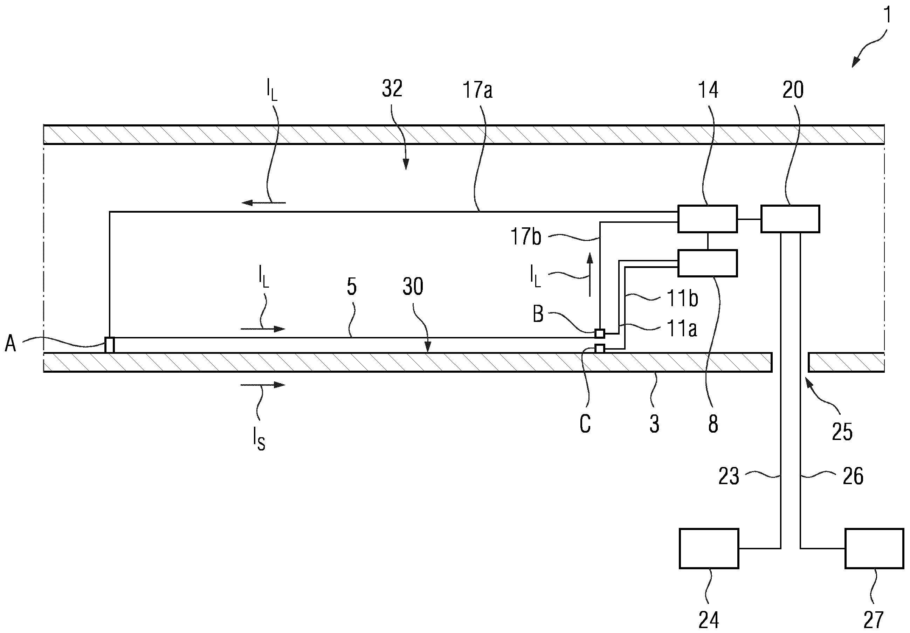

In der Figur ist in einer teilweisen Schnittdarstellung ein Ausführungsbeispiel einer Anordnung 1 zum Ermitteln der Größe eines durch eine Stromschiene 3 fließenden Stroms $I_S$ dargestellt. Bei der Stromschiene 3 handelt es sich im Ausführungsbeispiel um eine rohrförmige Stromschiene, von der lediglich zwei gegenüberliegende Wandbereiche im Schnitt dargestellt sind. Die Stromschiene 3 kann insbesondere eine hohlzylinderförmige Stromschiene sein. Die Stromschiene 3 weist einen ersten Kontaktpunkt A und einen dritten Kontaktpunkt C auf. Der Strom $I_S$ fließt durch die Stromschiene vom ersten Kontaktpunkt A in Richtung des dritten Kontaktpunkts C. Aufgrund des ohmschen Widerstands der Stromschiene entsteht durch den fließenden Strom $I_S$ eine elektrische Potenzialdifferenz (Spannung) zwischen dem ersten Kontaktpunkt A und dem dritten Kontaktpunkt C.

Der Abschnitt der Stromschiene zwischen dem ersten Kontaktpunkt A und dem dritten Kontaktpunkt C dient also bei der Anordnung als ein Mess-Shunt zur Messung des durch die Stromschiene 3 fließenden elektrischen Stroms (Strommess-Shunt). Es wird also vorteilhafterweise kein zusätzlicher Mess-Shunt benötigt.

Ein Messleiter 5 ist an dem ersten Kontaktpunkt A elektrisch mit der Stromschiene 3 verbunden. Abgesehen von der elektrischen Verbindung an dem ersten Kontaktpunkt A ist der Messleiter 5 elektrisch von der Stromschiene 3 isoliert. Dies ist in der Figur schematisch durch einen Abstand zwischen dem Messleiter 5 und der Stromschiene 3 angedeutet. Der Messleiter 5 ist also an dem ersten Kontaktpunkt A elektrisch mit der Stromschiene 3 verbunden und ansonsten von der Stromschiene 3 elektrisch isoliert angeordnet. Mit anderen Worten gesagt, ist der Messleiter 5 gegenüber der Stromschiene 3 elektrisch isoliert angeordnet und (ausschließlich) an dem ersten Kontaktpunkt A elektrisch mit der Stromschiene 3 verbunden. Der Messleiter 5 kann ein einfacher Leiter 5 sein (zum Beispiel ein einfacher Draht 5), dessen Querschnittsfläche wesentlich kleiner ist als die Querschnittsfläche der Stromschiene 3. Der Messleiter kann auch als ein Referenzleiter bezeichnet werden.

Der Messleiter 5 erstreckt sich von dem ersten Kontaktpunkt A zu einem zweiten Kontaktpunkt B. Im Ausführungsbeispiel ist die Länge des Messleiters zwischen dem ersten Kontaktpunkt A und dem zweiten Kontaktpunkt B gleich groß wie die Länge des Strompfades der Stromschiene zwischen dem ersten Kontaktpunkt A und dem dritten Kontaktpunkt C. Mit anderen Worten entspricht die Länge des Strompfades in der Stromschiene 3 zwischen dem ersten Kontaktpunkt A und dem dritten Kontaktpunkt C im Wesentlichen der Länge des Strompfads in dem Messleiter 5 zwischen dem ersten Kontaktpunkt A und dem zweiten Kontaktpunkt B. In anderen Ausführungsbeispielen können diese Längen jedoch auch unterschiedlich sein.

Weiterhin weist die Anordnung 1 eine Spannungsmesseinrichtung 8 auf, welche mittels einer ersten Spannungsmessleitung 11a mit dem zweiten Kontaktpunkt B und mittels einer zweiten Spannungsmessleitung 11b mit dem dritten Kontaktpunkt C elektrisch verbunden ist. Die Spannungsmesseinrichtung 8 dient zum Messen einer zwischen dem zweiten Kontaktpunkt B und dem dritten Kontaktpunkt C auftretenden Spannung. Die Spannungsmesseinrichtung 8 ist elektrisch verbunden mit einer regelbaren/geregelten Stromquelle 14. Diese Stromquelle 14 ist mittels einer ersten Einspeiseleitung 17a mit dem ersten Kontaktpunkt A elektrisch verbunden. Die Stromquelle 14 ist außerdem mittels einer zweiten Einspeiseleitung 17b mit dem zweiten Kontaktpunkt B elektrisch verbunden. Die geregelte Stromquelle 14 leitet einen Strom $I_L$ in den Messleiter 5 ein. Dieser Strom $I_L$ fließt von der Stromquelle 14 über die erste Einspeiseleitung 17a, den ersten Kontaktpunkt A, den Messleiter 5, den zweiten Kontaktpunkt B und die zweite Einspeiseleitung 17b zu der Stromquelle 14 zurück. Der durch den Messleiter 5 fließende Messstrom $I_L$ kann dabei sehr viel kleiner sein als der durch die Stromschiene 3 fließende, zu ermittelnde Strom $I_S$. Beispielsweise kann der durch die Stromschiene 3 fließende Strom $I_S$ im Kiloamperebereich liegen, währenddessen der Messstrom $I_L$ im Milliamperebereich liegen kann. Dadurch ergeben sich nur geringe Anforderungen an die geregelte Stromquelle 14. Zum Beispiel kann der Messstrom $I_L$ um einen Faktor kleiner sein als der durch die Stromschiene 3 fließende Strom $I_S$, wobei der Faktor zwischen $10^4$ und $10^6$, insbesondere zwischen $10^5$ und $10^6$, liegt. Der Messleiter 5 ist im Wesentlichen in Flussrichtung des durch die Stromschiene fließenden Stroms $I_S$ ausgerichtet.

Der durch den Messleiter 5 fließende Strom $I_L$ bewirkt einen Potenzialunterschied zwischen dem ersten Kontaktpunkt A und dem zweiten Kontaktpunkt B. Mittels der geregelten Stromquelle 14 wird der durch den Messleiter 5 fließende Strom $I_L$ so geregelt, dass die zwischen dem zweiten Kontaktpunkt B und dem dritten Kontaktpunkt C auftretende Spannung einen vorgewählten (vorbestimmten) Wert annimmt. Im Ausführungsbeispiel wird die Größe des Messstroms $I_L$ so geregelt, dass diese Spannung den Wert Null annimmt. In anderen Ausführungsbeispielen kann die Größe des Messstroms $I_L$ aber auch so geregelt werden, dass diese Spannung einen anderen vorgewählten Wert annimmt.

Sobald die Spannung zwischen dem zweiten Kontaktpunkt B und dem dritten Kontaktpunkt C den vorgewählten Wert (hier: den Wert Null) angenommen hat, wird die Größe des zugehörigen Messstroms $I_L$ in einer Auswerteeinrichtung 20 ausgewertet bzw. weiterverarbeitet. Diese Auswerteeinrichtung 20 ermittelt aus der Größe des Messstroms $I_L$ und aus der für die Stromleitung wirksamen Querschnittsfläche $A_L$ des Messleiters 5 und der für die Stromleitung wirksamen Querschnittsfläche $A_S$ der Stromschiene 3 die Größe des durch die Stromschiene fließenden Stroms $I_S$. Die wirksame Querschnittsfläche $A_L$ des Messleiters 5 sowie die wirksame Querschnittsfläche $A_S$ der Stromschiene 3 sind bekannt und als Konstanten in der Auswerteeinrichtung 20 abgespeichert. Dabei ermittelt die Auswerteeinrichtung die Größe des durch die Stromschiene fließenden Stroms $I_S$ gemäß der Beziehung

$$I_S = k \ I_L \ A_S/A_L$$

Dabei ist $I_S$ der durch die Stromschiene fließende Strom, k eine Proportionalitätskonstante, $I_L$ der Messstrom, $A_S$ die für die Stromleitung wirksame Querschnittsfläche der Stromschiene und $A_L$ die für die Stromleitung wirksame Querschnittsfläche des Messleiters.

Im Ausführungsbeispiel bestehen der Messleiter 5 und die Stromschiene 3 aus demselben Material, beispielsweise aus Kupfer, Aluminium oder einer Legierung mit einem dieser Metalle. Im Allgemeinen kann auch ein anderes stromleitendes Material verwendet werden, insbesondere ein Metall. Der Messleiter 5 und die Stromschiene 3 weisen also denselben spezifischen Widerstandswert auf. Außerdem ist der elektrisch wirksame Abstand zwischen dem ersten Kontaktpunkt A und dem zweiten Kontaktpunkt B gleich lang wie der elektrisch wirksame Abstand zwischen dem ersten Kontaktpunkt A und dem dritten Kontaktpunkt C. Mit anderen Worten ist die Länge des Strompfades in der Stromschiene zwischen dem ersten Kontaktpunkt A und dem dritten Kontaktpunkt C im Wesentlichen gleich lang wie die Länge des Strompfades in dem Messleiter 5 zwischen dem ersten Kontaktpunkt A und dem zweiten Kontaktpunkt B. In diesem Fall weist die Proportionalitätskonstante k den Wert 1 auf (k= 1). Diese Proportionalitätskonstante k kann in anderen Ausführungsbeispielen jedoch auch andere Werte als 1 annehmen.

Die Auswerteeinrichtung 20 ist über einen Energieübertragungskanal 23 mit einer Energieversorgungseinrichtung 24 verbunden. Der Energieübertragungskanal 23 kann beispielsweise als ein erster Lichtquellenleiter oder als ein erster elektrischer Leiter ausgestaltet sein. Über den Energieübertragungskanal 23 werden die elektronischen Einrichtungen der Anordnung 1 mit elektrischer Energie versorgt. Das heißt, die Spannungsmesseinrichtung 8, die Stromquelle 14 und die Auswerteeinrichtung 20 werden über den Energieübertragungskanal 23 mit elektrischer Energie versorgt. Im Ausführungsbeispiel ist die Energieversorgungseinrichtung 24 außerhalb der Stromschiene 3 angeordnet. Der Energieübertragungskanal 23 verläuft vom Innenraum der rohrförmigen Stromschiene über eine Ausnehmung 25 in der Wandung der Stromschiene zu der Energieversorgungseinrichtung 24. Wenn die Stromschiene 3 auf Hochspannungspotential betrieben wird, ist die Ausgestaltung des Energieübertragungskanals 23 als ein Lichtwellenleiter vorteilhaft, durch den dann eine elektrische Potenzialtrennung realisiert wird.

Weiterhin ist die Auswerteeinrichtung 20 mittels eines Kommunikationskanals 26 mit einer datenverarbeitenden Einrichtung 27 verbunden. Der Kommunikationskanal 26 kann beispielsweise als ein zweiter Lichtquellenleiter oder als ein zweiter elektrischer Leiter ausgestaltet sein. Die datenverarbeitende Einrichtung 27 kann dabei zum Beispiel einen Datenempfänger und/oder einen Datenspeicher aufweisen. Diese datenverarbeitende Einrichtung 27 kann beispielsweise ein auf Erdpotenzial angeordneter Rechner sein. Die Auswerteeinrichtung 20 überträgt insbesondere die ermittelte Größe des durch die Stromschiene 3 fließenden elektrischen Stroms $I_S$ über den Kommunikationskanal 26 zu der datenverarbeitenden Einrichtung 27. Außerdem können optional über den Kommunikationskanal 26 weitere Daten von der Auswerteeinrichtung 20 zu der datenverarbeitenden Einrichtung 27 übermittelt werden. Optional können auch in umgekehrter Richtung Daten von der datenverarbeitenden Einrichtung 27 über den Kommunikationskanal 26 zu der Auswerteeinrichtung 20 übermittelt werden.

Im Ausführungsbeispiel ist der Messleiter 5 an einer Oberfläche 30 der Stromschiene 3 angeordnet. Konkret ist der Messleiter 5 an der inneren Oberfläche 30 der rohrförmigen Stromschiene 3 angeordnet, also in einem Innenraum 32 der rohrförmigen Stromschiene 3. Der Messleiter 5 kann beispielsweise auf diese Oberfläche der Stromschiene geklebt sein mittels eines elektrisch isolierenden Klebstoffes. Dadurch wird der Messleiter 5 (abgesehen vom ersten Kontaktpunkt A) gegenüber der Stromschiene 3 elektrisch isoliert. Die Anordnung und das Verfahren können grundsätzlich zur Messung/Ermittlung des durch die Stromschiene 3 fließenden Stroms bei beliebigen Spannungen eingesetzt werden. Besonders vorteilhaft ist diese Anordnung und das Verfahren aber bei Stromschienen, die auf Hochspannungspotenzial liegen. Mittels der Anordnung und des Verfahrens kann nämlich der Strom auf Hochspannungspotenzial mit einer hohen Genauigkeit und einer hohen Dynamik (d.h. in einem großen Frequenzbereich) ermittelt werden. Dies ist beispielsweise vorteilhaft für die Regelung und den Schutz von Hochspannungs-Stromrichtern (zum Beispiel für die Hochspannungs-Gleichstromübertragung) oder für die Ermittlung einer über die Stromschiene 3 übertragenen elektrischen Leistung (beispielsweise zum Zwecke der Abrechnung der Leistungsübertragung).

Vorstehend wurden die Anordnung und das Verfahren am Beispiel einer rohrförmigen Stromschiene beschrieben. Die Anordnung und das Verfahren können aber auch mit einer anderen Stromschiene realisiert werden, beispielsweise mit einer flachbandförmigen Stromschiene.

Die beschriebene Anordnung und das beschriebene Verfahren weisen eine Reihe von Vorteilen auf:
Die Anordnung 1 und das beschriebene Verfahren weisen einen großen Messdynamikbereich auf, weil ein Teil der Stromschiene 3 als Strom-Messshunt verwendet wird und zusätzlich nur ein einfacher Messleiter 5 notwendig ist. Im Unterschied dazu müsste bei der Verwendung von zusätzlichen widerstandsbasierten Bauelementen als Strom-Messshunts aufgrund derer komplizierteren Konstruktion und Materialwahl mit deutlichen Einschränkungen der Messdynamik gerechnet werden. Weiterhin ist vorteilhafterweise keine Temperaturmessung und keine Temperaturkompensation erforderlich, weil der Messleiter im Wesentlichen eine definierte Temperatur annimmt, nämlich die Temperatur der Stromschiene 3. Es entsteht auch keine nennenswerte zusätzliche Verlustleistung, weil durch den Messleiter 5 nur ein vergleichsweise kleiner Strom fließt. Weiterhin ist keine aufwendige mechanische Konstruktion zur Befestigung der Anordnung (insbesondere auf Hochspannungspotenzial) erforderlich, da die Anordnung vorzugsweise im Inneren/im Innenraum der rohrförmigen Stromschiene 3 angeordnet ist. Wenn der Messleiter 5 aus demselben Material besteht wie die Stromschiene 3, dann kann auch auf teure Speziallegierungen für den Messleiter verzichtet werden. Der spezifische Widerstand des Messleiters ist dann gleich dem spezifischen Widerstand der Stromschiene, so dass der durch die Stromschiene 3 fließende Strom sehr einfach ermittelt werden kann aus dem Messstrom $I_L$ und dem Verhältnis der Querschnittsflächen der Stromschiene und des Messleiters.

Die Anordnung 1 und das Verfahren lassen sich einfach und kostengünstig realisieren, da neben der sowieso vorhandenen Stromschiene und der Spannungsmesseinrichtung 8, Stromquelle 14 und Auswerteeinrichtung 20 lediglich ein kostengünstiger Messleiter 5 erforderlich ist. Der Messleiter sowie die elektronischen Einrichtungen (Spannungsmesseinrichtung 8, Stromquelle 14, Auswerteeinrichtung 20) liegen geschützt im Inneren der rohrförmigen Stromschiene, insbesondere witterungsgeschützt und in einem nahezu feldfreien Raum. Das Gewicht der Anordnung ist wesentlich geringer, als das Gewicht eines zusätzlichen Shunt-Widerstands für große Ströme wäre. Außerdem ist keine aufwendige Isolation erforderlich, da die wesentlichen Komponenten der Anordnung auf dem Potenzial der Stromschiene angeordnet sind. Die Messgenauigkeit der Anordnung wird von thermischen Einflüssen kaum beeinträchtigt, da die Anordnung auf einer definierten Temperatur liegt, insbesondere die Temperatur der Stromschiene annimmt. Durch entsprechende Wahl der Querschnittsfläche des Messleiters, der Querschnittsfläche der Stromschiene, der Länge des Strompfads zwischen dem ersten Kontaktpunkt A und dem dritten Kontaktpunkt C und/oder der Länge des Strompfads zwischen dem ersten Kontaktpunkt A und dem zweiten Kontaktpunkt B können für den Messstrom $I_L$ sowie für die zu messende Spannung zwischen dem zweiten Kontaktpunkt B und dem dritten Kontaktpunkt C gut geeignete Werte gewählt werden, beispielsweise gut für die Auswertung in der Auswerteeinrichtung 20 geeignete Werte. Insbesondere kann der Querschnitt des Messleiters 5 so gewählt werden, dass der Messstrom $I_L$ in einem gewünschten Bereich liegt, der kostengünstig mittels der Stromquelle 14 abgedeckt werden kann. Eine zusätzliche aufwendige Ausstattung der Stromschiene mit Koronaringen oder ähnlichem ist nicht notwendig.

Für den Messleiter 5 ist insbesondere ein Leiter mit einer geringen Querschnittsfläche (und damit einem sehr geringen Volumen) ausreichend. Daher kann dieser Messleiter einfach von innen an der Oberfläche der rohrförmigen Stromschiene angebracht (zum Beispiel auf die innere Oberfläche der rohrförmigen Stromschiene geklebt) sein. Vorteilhafterweise hat der Messleiter 5 dieselbe Temperatur wie die Stromschiene 3. Somit wird der thermische Einfluss kompensiert, ohne dass dafür aufwendige Kompensationsschaltungen notwendig sind. Wenn der Messleiter 5 und die Stromschiene 3 aus demselben Material bestehen, dann weisen beide Elemente auch denselben spezifischen Widerstand auf. Bei der Ermittlung des durch die Stromschiene fließenden Stroms braucht lediglich ein (kleiner) Strom (Messstrom $I_L$) über den Messleiter 5 getrieben werden und die Spannungsdifferenz zwischen dem zweiten Kontaktpunkt und dem dritten Kontaktpunkt auf einen vorbestimmten Wert, insbesondere auf Null, geregelt werden. Dies ist einfach und präzise mit kostengünstiger Technik möglich. Insgesamt lässt sich das beschriebene Verfahren und die beschriebene Anordnung kostengünstig realisieren, und es wird dennoch eine zuverlässige und robuste Lösung zur Ermittlung der Größe eines durch die Stromschiene fließenden Stroms (auch auf Hochspannungspotenzial und/oder bei hohen Frequenzen) ermöglicht.

**Patentansprüche**

1.  Anordnung (1) zum Ermitteln der Größe eines durch eine Stromschiene fließenden Stroms ($I_S$), mit

    - einer Stromschiene (3),
    - einem Messleiter (5), der an einem ersten Kontaktpunkt (A) elektrisch mit der Stromschiene (3) verbunden ist und der sich von dem ersten Kontaktpunkt (A) zu einem zweiten Kontaktpunkt (B) erstreckt,
    - einem dritten Kontaktpunkt (C), der an der Stromschiene (3) beabstandet von dem ersten Kontaktpunkt (A) angeordnet ist,
    - einer Spannungsmesseinrichtung (8), die zum Messen einer zwischen dem zweiten Kontaktpunkt (B) und dem dritten Kontaktpunkt (C) auftretenden Spannung eingerichtet ist, und
    - einer geregelten Stromquelle (14), die zum Einleiten eines Messstroms ($I_L$) in den Messleiter eingerichtet ist,

    **dadurch gekennzeichnet, dass**

    - die Größe des Messstroms ($I_L$) so geregelt ist, dass die zwischen dem zweiten Kontaktpunkt (B) und dem dritten Kontaktpunkt (C) auftretende Spannung einen vorgewählten Wert, insbesondere den Wert Null, annimmt, und
    - die Anordnung eine Auswerteeinrichtung (20) aufweist, welche die Größe des durch die Stromschiene (3) fließenden Stroms ($I_S$) ermittelt aus der Größe des Messstroms ($I_L$), der für die Stromleitung wirksamen Querschnittsfläche des Messleiters (5) und der für die Stromleitung wirksamen Querschnittsfläche der Stromschiene (3).

2.  Anordnung nach Anspruch 1,
    **dadurch gekennzeichnet, dass**

    - die Auswerteeinrichtung (20) die Größe des durch die Stromschiene fließenden Stroms ($I_S$) ermittelt gemäß der Beziehung

    $$I_S = k\ I_L\ A_S/A_L$$

    wobei $I_S$ der durch die Stromschiene fließende Strom, keine Proportionalitätskonstante, $I_L$ der Messstrom, $A_S$ die für die Stromleitung wirksame Querschnittsfläche der Stromschiene und $A_L$ die für die Stromleitung wirksame Querschnittsfläche des Messleiters ist.

3.  Anordnung nach einem der vorhergehenden Ansprüche, **dadurch gekennzeichnet, dass**

    - der Messleiter (5) und die Stromschiene (3) aus demselben Material bestehen.

4.  Anordnung nach einem der vorhergehenden Ansprüche, **dadurch gekennzeichnet, dass**

    - der Messleiter (5) an einer Oberfläche der Stromschiene (3) angeordnet ist.

5.  Anordnung nach einem der vorhergehenden Ansprüche, **dadurch gekennzeichnet, dass**

    - der Messleiter (5) im Wesentlichen in Flussrichtung des durch die Stromschiene (3) fließenden Stroms ($I_S$) an der Oberfläche der Stromschiene (3) angeordnet ist.

6.  Anordnung nach einem der vorhergehenden Ansprüche, **dadurch gekennzeichnet, dass**

    - die Stromschiene (3) eine rohrförmige Stromschiene ist.

7.  Anordnung nach Anspruch 6, **dadurch gekenn-**

zeichnet, dass

- der Messleiter (5) an der inneren Oberfläche der rohrförmigen Stromschiene (3) angeordnet ist.

8. Anordnung nach Anspruch 6 oder 7, **dadurch gekennzeichnet, dass**

- der Messleiter (5), die Spannungsmesseinrichtung (8), die geregelte Stromquelle (14) und/oder die Auswerteeinrichtung (20) im Innenraum der rohrförmigen Stromschiene (3) angeordnet sind.

9. Anordnung nach einem der vorhergehenden Ansprüche, **dadurch gekennzeichnet, dass**

- der Messleiter (5) auf die Oberfläche der Stromschiene (3) geklebt ist.

10. Anordnung nach einem der vorhergehenden Ansprüche, **gekennzeichnet durch**

- einen Energieübertragungskanal (23) zur Energieversorgung der Spannungsmesseinrichtung (8), der geregelten Stromquelle (14) und/oder der Auswerteeinrichtung (20).

11. Anordnung nach einem der vorhergehenden Ansprüche, **gekennzeichnet durch**

- einen Kommunikationskanal (26) zur Übertragung der ermittelten Größe des durch die Stromschiene (3) fließenden elektrischen Stroms ($I_S$).

12. Anordnung nach einem der vorhergehenden Ansprüche, **gekennzeichnet durch**

- die Länge des Strompfads in der Stromschiene (3) zwischen dem ersten Kontaktpunkt (A) und dem dritten Kontaktpunkt (C) im Wesentlichen der Länge des Strompfads in dem Messleiter (5) zwischen dem ersten Kontaktpunkt (A) und dem zweiten Kontaktpunkt (B) entspricht.

13. Verfahren zum Ermitteln der Größe eines durch eine Stromschiene fließenden Stroms, mit

- einem Messleiter (5), der an einem ersten Kontaktpunkt (A) elektrisch mit der Stromschiene (3) verbunden ist und der sich von dem ersten Kontaktpunkt (A) zu einem zweiten Kontaktpunkt (B) erstreckt,
- einem dritten Kontaktpunkt (C), der an der Stromschiene (3) beabstandet von dem ersten Kontaktpunkt (A) angeordnet ist, wobei bei dem Verfahren

- die zwischen dem zweiten Kontaktpunkt (B) und dem dritten Kontaktpunkt (C) auftretende Spannung gemessen wird, und
- in den Messleiter (5) ein Messstrom ($I_L$) eingeleitet wird, **dadurch gekennzeichnet, dass**
- die Größe des Messstroms ($I_L$) so geregelt wird, dass die zwischen dem zweiten Kontaktpunkt (B) und dem dritten Kontaktpunkt (C) auftretende Spannung einen vorgewählten Wert, insbesondere den Wert Null, annimmt, und
- die Größe des durch die Stromschiene (3) fließenden Stroms ($I_S$) ermittelt wird aus der Größe des Messstroms ($I_L$), der für die Stromleitung wirksamen Querschnittsfläche des Messleiters (5) und der für die Stromleitung wirksamen Querschnittsfläche der Stromschiene (3).

14. Verfahren nach Anspruch 13, **dadurch gekennzeichnet, dass**

- die Größe des durch die Stromschiene fließenden Stroms ermittelt wird gemäß der Beziehung

$$I_S = k \ I_L \ A_S / A_L$$

wobei $I_S$ der durch die Stromschiene fließende Strom, keine Proportionalitätskonstante, $I_L$ der Messstrom, $A_S$ die für die Stromleitung wirksame Querschnittsfläche der Stromschiene und $A_L$ die für die Stromleitung wirksame Querschnittsfläche des Messleiters ist.

15. Verfahren nach Anspruch 13 oder 14, **dadurch gekennzeichnet, dass**

- der Messleiter (5) und die Stromschiene (3) aus demselben Material bestehen.

**Claims**

1. Arrangement (1) for determining the magnitude of a current ($I_S$) flowing through a busbar, with

- a busbar (3),
- a measurement conductor (5) which is electrically connected to the busbar (3) at a first contact point (A) and which extends from the first contact point (A) to a second contact point (B),
- a third contact point (C) which is arranged at the busbar (3) spaced apart from the first contact point (A),
- a voltage measurement device (8) which is set up for measuring a voltage which occurs between the second contact point (B) and the third contact point (C), and
- a controlled current source (14) which is set up for introducing a measurement current ($I_L$) into the measurement conductor,

**characterized in that**

- the magnitude of the measurement current ($I_L$) is controlled in such a way that the voltage which occurs between the second contact point (B) and the third contact point (C) assumes a preselected value, in particular the value zero, and
- the arrangement has an evaluation device (20) which determines the magnitude of the current ($I_S$) flowing through the busbar (3) from the magnitude of the measurement current ($I_L$), the cross-sectional area of the measurement conductor (5) which is effective for the current line and the cross-sectional area of the busbar (3) which is effective for the current line.

2. Arrangement according to Claim 1, **characterized in that**

- the evaluation device (20) determines the magnitude of the current ($I_S$) flowing through the busbar according to the relationship

$$I_S = k\ I_L\ A_S/A_L$$

wherein $I_S$ is the current flowing through the busbar, k is a proportionality constant, $I_L$ is the measurement current, $A_S$ is the cross-sectional area of the busbar which is effective for the current line and $A_L$ is the cross-sectional area of the measurement conductor which is effective for the current line.

3. Arrangement according to either of the preceding claims, **characterized in that**

- the measurement conductor (5) and the busbar (3) consist of the same material.

4. Arrangement according to one of the preceding claims, **characterized in that**

- the measurement conductor (5) is arranged on a surface of the busbar (3).

5. Arrangement according to one of the preceding claims, **characterized in that**

- the measurement conductor (5) is arranged on the surface of the busbar (3) substantially in the flow direction of the current ($I_S$) flowing through the busbar (3).

6. Arrangement according to one of the preceding claims, **characterized in that**

- the busbar (3) is a tubular busbar.

7. Arrangement according to Claim 6, **characterized in that**

- the measurement conductor (5) is arranged on the inner surface of the tubular busbar (3).

8. Arrangement according to Claim 6 or 7, **characterized in that**

- the measurement conductor (5), the voltage measurement device (8), the controlled current source (14) and/or the evaluation device (20) are arranged in the interior of the tubular busbar (3).

9. Arrangement according to one of the preceding claims, **characterized in that**

- the measurement conductor (5) is bonded to the surface of the busbar (3).

10. Arrangement according to one of the preceding claims, **characterized by**

- an energy transmission channel (23) for supplying energy to the voltage measurement device (8), the controlled current source (14) and/or the evaluation device (20).

11. Arrangement according to one of the preceding claims, **characterized by**

- a communication channel (26) for transmitting the determined magnitude of the electric current ($I_S$) flowing through the busbar (3).

12. Arrangement according to one of the preceding claims, **characterized in that**

- the length of the current path in the busbar (3) between the first contact point (A) and the third contact point (C) substantially corresponds to the length of the current path in the measurement conductor (5) between the first contact point (A) and the second contact point (B).

13. Method for determining the magnitude of a current flowing through a busbar, with

- a measurement conductor (5) which is electrically connected to the busbar (3) at a first contact point (A) and which extends from the first contact point (A) to a second contact point (B),
- a third contact point (C) which is arranged at the busbar (3) spaced apart from the first contact point (A),

wherein, in the method,

- the voltage which occurs between the second contact point (B) and the third contact point (C) is measured, and
- a measurement current ($I_L$) is introduced into the measurement conductor (5),

**characterized in that**

- the magnitude of the measurement current ($I_L$) is controlled in such a way that the voltage which occurs between the second contact point (B) and the third contact point (C) assumes a preselected value, in particular the value zero, and
- the magnitude of the current ($I_S$) flowing through the busbar (3) is determined from the magnitude of the measurement current ($I_L$), the cross-sectional area of the measurement conductor (5) which is effective for the current line and the cross-sectional area of the busbar (3) which is effective for the current line.

14. Method according to Claim 13,
**characterized in that**

- the magnitude of the current flowing through the busbar is determined according to the relationship

$$I_S = k\ I_L\ A_S/A_L$$

wherein $I_S$ is the current flowing through the busbar, k is a proportionality constant, $I_L$ is the measurement current, $A_S$ is the cross-sectional area of the busbar which is effective for the current line and $A_L$ is the cross-sectional area of the measurement conductor which is effective for the current line.

15. Method according to Claim 13 or 14,
**characterized in that**

- the measurement conductor (5) and the busbar (3) consist of the same material.

**Revendications**

1. Installation (1) de détermination de la grandeur d'un courant ($I_s$) passant dans une barre omnibus, comprenant :

- une barre (3) omnibus,
- un conducteur (5) de mesure, qui est relié, en un premier point (A) de contact, électriquement à la barre (3) omnibus et qui s'étend du premier point (A) de contact à un deuxième point (B) de contact,

- un troisième point (C) de contact, qui est à distance sur la barre (3) omnibus du premier point (A) de contact,
- un dispositif (8) de mesure de la tension, qui est agencé pour la mesure d'une tension apparaissant entre le deuxième point (B) de contact et le troisième point (C) de contact, et
- une source (14) de courant régulée, qui est agencée pour envoyer un courant ($I_L$) de mesure dans le conducteur de mesure, **caractérisée en ce que**
- la grandeur du courant ($I_L$) de mesure est régulée de manière à ce que la tension apparaissant entre le deuxième point (B) de contact et le troisième point (C) de contact prenne une valeur sélectionnée à l'avance, en particulier la valeur zéro, et
- l'installation a un dispositif (20) d'analyse, qui détermine la grandeur du courant ($I_S$) passant dans la barre (3) omnibus à partir de la grandeur du courant ($I_L$) de mesure de la surface de section transversale efficace pour la conduction du courant du conducteur (5) de mesure et de la surface de la section transversale efficace pour la conduction du courant de la barre (3) omnibus.

2. Installation suivant la revendication 1, **caractérisée en ce que**

- le dispositif (20) d'analyse détermine la grandeur du courant ($I_S$) passant dans la barre omnibus suivant la relation

$$I_S = k\ I_L\ A_S/A_L$$

dans laquelle $I_S$ est le courant passant dans la barre omnibus, k une constante de proportionnalité, $I_L$ le courant de mesure, $A_S$ la surface de section transversale efficace pour la conduction du courant de la barre omnibus et $A_L$ la surface de la section transversale efficace pour la conduction du courant du conducteur de mesure.

3. Installation suivant l'une des revendications précédentes, **caractérisée en ce que**

- le conducteur (5) de mesure et la barre (3) omnibus sont en le même matériau.

4. Installation suivant l'une des revendications précédentes, **caractérisée en ce que**

- le conducteur (5) de mesure est disposé sur une surface de la barre (3) omnibus.

5. Installation suivant l'une des revendications précédentes, **caractérisée en ce que**

- le conducteur (5) de mesure est disposé sur la surface de la barre (3) omnibus sensiblement dans la direction du flux du courant ($I_S$) passant dans la barre (3) omnibus.

6. Installation suivant l'une des revendications précédentes, **caractérisée en ce que**

- la barre (3) omnibus est une barre omnibus tubulaire.

7. Installation suivant la revendication 6, **caractérisée en ce que**

- le conducteur (5) de mesure est disposé sur une surface intérieure de la barre (3) omnibus tubulaire.

8. Installation suivant la revendication 6 ou 7, **caractérisée en ce que**

- le conducteur (5) de mesure, le dispositif (8) de mesure de la tension, la source (14) de courant régulée et/ou le dispositif (20) d'analyse sont disposés à l'intérieur de la barre (3) omnibus tubulaire.

9. Installation suivant l'une des revendications précédentes, **caractérisée en ce que**

- le conducteur (5) de mesure est collé à la surface de la barre (3) omnibus.

10. Installation suivant l'une des revendications précédentes, **caractérisée par**

- un canal (23) de transmission d'énergie pour l'alimentation en énergie du dispositif (8) de mesure de la tension de la source (14) de courant régulée et/ou du dispositif (20) d'analyse.

11. Installation suivant l'une des revendications précédentes, **caractérisée par**

- un canal (26) de communication pour la transmission de la grandeur déterminée du courant ($I_S$) électrique passant dans la barre (3) omnibus.

12. Installation suivant l'une des revendications précédentes, **caractérisée par**

- la longueur du chemin de courant dans la barre (3) omnibus entre le premier point (A) de contact et le troisième point (C) de contact correspond sensiblement à la longueur du chemin de courant dans le conducteur (5) de mesure entre le premier point (A) de contact et le deuxième point (B) de contact.

13. Procédé de détermination de la grandeur d'un courant passant dans une barre omnibus, comprenant

- un conducteur (5) de mesure, qui est relié, en un premier point (A) de contact, électriquement à la barre (3) omnibus et qui s'étend du premier point (A) de contact à un deuxième point (B) de contact,
- un troisième point (C) de contact, qui est à distance sur la barre (3) omnibus du premier point (A) de contact,

dans lequel dans le procédé

- on mesure la tension apparaissant entre le deuxième point (B) de contact et le troisième point (C) de contact, et
- on envoie un courant ($I_L$) de mesure dans le conducteur (5) de mesure,

**caractérisé en ce que**

- on régule la grandeur du courant ($I_L$) de mesure de manière à ce que la tension apparaissant entre le deuxième point (B) de contact et le troisième point (C) de contact prenne une valeur sélectionnée à l'avance, en particulier la valeur zéro, et
- on détermine la grandeur du courant ($I_S$) passant dans la barre (3) omnibus à partir de la grandeur du courant ($I_L$) de mesure de la surface de la section transversale efficace pour la conduction du courant du conducteur (5) de mesure et de la surface de section transversale efficace pour la conduction du courant de la barre (3) omnibus.

14. Procédé suivant la revendication 13, **caractérisé en ce que**

- on détermine la grandeur du courant passant dans la barre omnibus suivant la relation

$$I_S = k\ I_L\ A_S/A_L$$

dans laquelle $I_S$ est le courant passant dans la barre omnibus, k une constante de proportionnalité, $I_L$ le courant de mesure, $A_S$ la surface de section transversale efficace pour la conduction du courant de la barre omnibus et $A_L$ la surface de la section transversale efficace pour la conduction du courant du conducteur de mesure.

15. Procédé suivant la revendication 13 ou 14, **caractérisé en ce que**

- le conducteur (5) de mesure et la barre (3) omnibus sont en le même matériau.

EP 3 977 142 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2016291059 A1
- WO 2006002446 A1